# EUROPEAN PATENT APPLICATION

(11) **EP 1 835 544 A2**
(43) Date of publication of application: **19.09.2007**
(21) Application number: 07005474.7
(22) Date of filing: 16.03.2007
(51) Int. Cl.: H01L 29/78, H01L 29/739, H01L 29/417, H01L 29/06, H01L 29/08

(54) **Semiconductor device and manufacturing method of the same**

(30) Priority: 16.03.2006 JP 2006072645; 08.08.2006 JP 2006215906; 22.02.2007 JP 2007042703
(71) Applicant: Sanyo Electric Co. Ltd., Osaka 570-8677 (JP); Sanyo Semiconductor Co., Ltd., Oizumi-machi Ora-gun Gunma-ken 370-0596 (JP)
(72) Inventor: Yanagida, Masamichi, Gunma 373-0847 (JP); Kameyama, Koujiro, Gunma 373-0813 (JP); Okada, Kikuo, Saitama 369-0306 (JP)
(74) Representative: Glawe, Delfs, Moll

(57) **Abstract**

Thinning a semiconductor substrate (1) has been needed for reducing on-resistance in a semiconductor device such as a vertical MOS transistor, IGBT, or the like where a high current flows in the semiconductor substrate (1) in a vertical direction. In this case, the thinning is performed to the extent that the semiconductor substrate (1) does not warp with a heat treatment, so that there is a limitation in reduction of on-resistance. In the invention, openings (11) such as trench holes are formed on a back surface side of a semiconductor substrate (1). Then, a drain electrode (12) is formed being electrically connected with bottoms of these openings (11). In this case, a current path is formed short corresponding to the depths of the openings (11), thereby easily achieving low on-resistance.

## Description

### BACKGROUND OF THE INVENTION

### Field of the Invention

The invention relates to a semiconductor device and a method of manufacturing the same, particularly to a semiconductor device where a high current flows in a vertical direction of a semiconductor substrate and a method of manufacturing the same.

### Description of the Related Art

The vertical MOSFET is suitable as a high current element since it possesses a larger area through which a current flows than the lateral MOSFET where a source electrode and a drain electrode are arranged on the same surface.

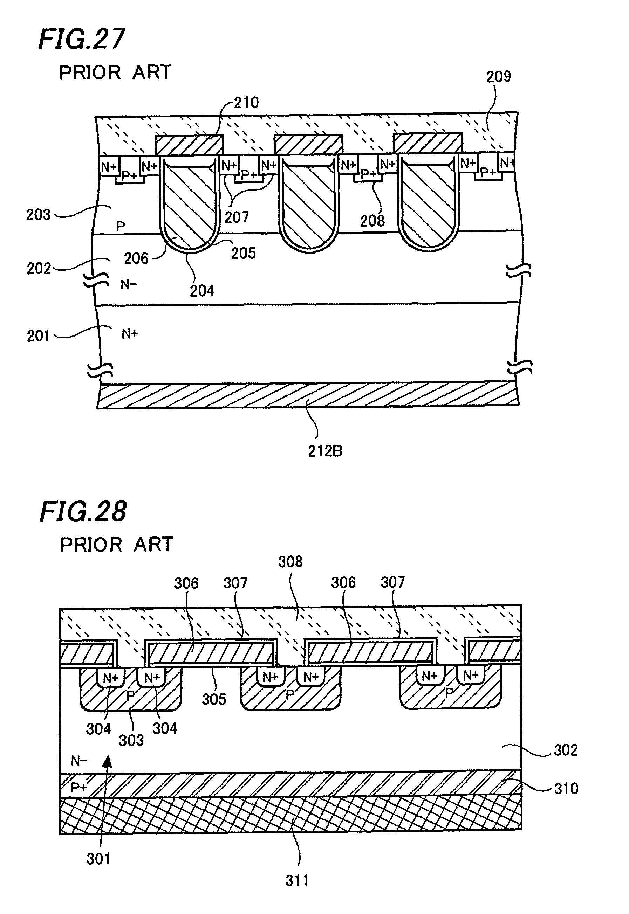

Fig. 27 is a conventional cross-sectional view of an example of the vertical MOS transistor.

An N⁻-type epitaxial layer 202 is formed on an N⁺-type semiconductor substrate 201, and a P-type channel layer 203 is formed on a front surface of the epitaxial layer 202. Trench grooves 204 are formed from a front surface of the channel layer 203 to a predetermined depth position of the epitaxial layer 202, and gate electrodes 206 made of a polysilicon film are formed in the trench grooves 204 with insulation layers 205 interposed therebetween. Furthermore, N⁺-type source layers 207 are formed on the front surface of the epitaxial layer 202 and on the sidewalls of the trench grooves 204, being adjacent to the insulation layers 205. P⁺-type body layers 208 are formed between the adjacent source layers 207. A source electrode 209 made of, for example, aluminum alloy is formed on the semiconductor substrate 201 (the epitaxial layer 202) over the source layers 207. Element isolation films 210 are formed on the gate electrodes 206, which insulate the gate electrodes 206 from the source electrode 209.

A drain electrode 212B is formed on a back surface side of the semiconductor substrate 201 by a vacuum evaporation process, forming a semiconductor device.

With this structure, channels are formed in the channel layer 203 along the gate electrodes 206 when a predetermined voltage is applied to the gate electrodes 206, and when a voltage is applied to the drain electrode 212B for the source electrodes 207, a current flows from the drain electrode 212B to the source layers 207 and then the source electrode 209 through the semiconductor substrate 201, the epitaxial layer 202, and the channel layer 203.

An insulated gate bipolar transistor is called IGBT, in which a fundamental cell combines the bipolar transistor and the MOSFET, forming a semiconductor device having both low on-voltage characteristics of the former and voltage drive characteristics of the latter.

Fig. 28 shows an example of a conventional NPT type IGBT.

A MOS structure is formed on a front surface side of an N⁻-type semiconductor substrate 301. In detail, P-type base regions 303 are selectively formed on a front surface of an N⁻-type drift region 302. Furthermore, N⁺-type emitter regions 304 are selectively formed on a front surfaces of the base regions 303. Gate electrodes 306 are formed thereon with gate oxide films 305 interposed therebetween, at least covering the front surface of the base regions 303 between the emitter regions 304 and the drift region 302. Furthermore, the gate electrodes 306 are surrounded by the insulation films 307, and an emitter electrode 308 is formed covering the insulation films 307 and being connected with the emitter regions 304.

A collector electrode 311 is formed on a back surface side of the semiconductor substrate 301, and a P⁺-type collector region 310 is formed being connected with the collector electrode 311.

With this structure, in an NPT type IGBT having, for example, a breakdown voltage of 600V, the drift region 302 and the collector region 310 are formed to have thicknesses of about 90 µm and 1 µm, respectively.

With this structure, when a positive voltage is applied to the gate electrodes 306 in the state where a positive voltage is applied to the collector electrode 310, channels are formed in the base regions 303 under the gate electrodes 306, and thus electrons are supplied to the drift regions 302 through these channels. Then, when these electrons reach the collector region 310 through the drift region 302, holes are supplied from the collector region 310 to the drift region 302, thereby achieving low on-resistance.

Since the amount of holes injected to the drift region 302 is small and the accumulation effect of minority carriers is low in the NPT type IGBT, when the voltage application is stopped, the holes accumulated in the drift region 302 are rapidly discharged through the collector electrode 310. Accordingly, this semiconductor device has short turn-off time, so that it is used as a high speed switching element or the like.

The relevant technology is described in the Japanese Patent Application Publication Nos. 2004-140101, 2005-129652, and 2001-119023, for example.

In these semiconductor devices, on-resistance has been lowered by increasing the cell density so far, while cell miniaturization is almost reaching the limit.

Therefore, there has been a demand for a thinner semiconductor substrate. That is, a semiconductor substrate is the largest resistance component of a current path in these semiconductor devices, and thus the thinning of a semiconductor substrate has been employed as means of reducing this component.

However, there are technological problems and difficulties in thinning the semiconductor substrate. Hereafter, these will be described taking the NPT type IGBT for an example, although these problems also occur in the vertical MOS transistors.

In the NPT type IBGT, the thickness of the drift region 302 is designed taking into account a breakdown voltage as well as optimization of on-resistance. For example, the drift region 302 is designed to have the thickness of about 90 µm for obtaining a breakdown voltage of 600V or the thickness of about 130 µm for obtaining a breakdown voltage of 1200V. The thickness of the drift region 302 is adjusted by grinding the semiconductor substrate 301 on its back side.

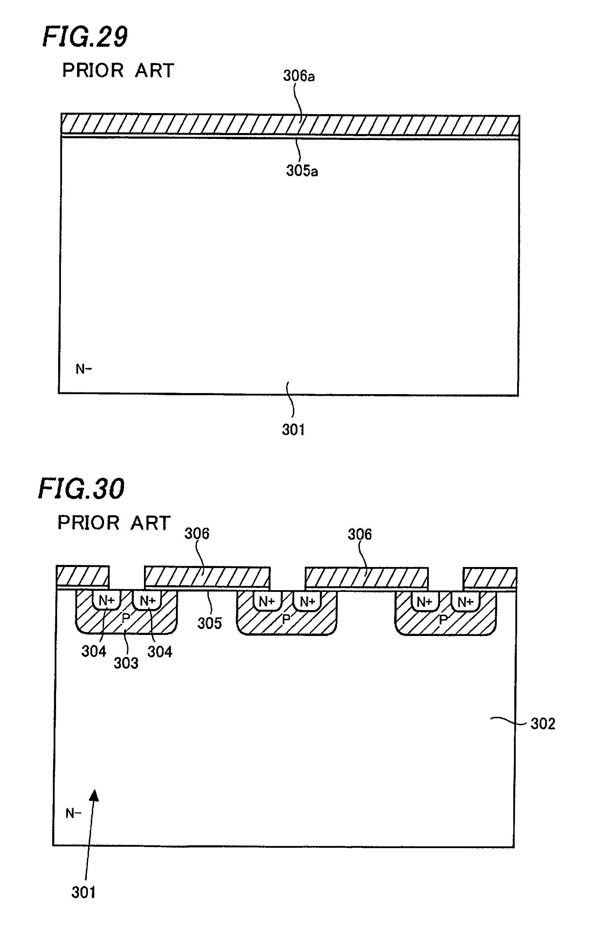

Hereafter, problems of conventional devices will be described in detail by explaining a method of manufacturing the NPT type IBGT, referring to Figs. 29 to 32.

First, as shown in Fig. 29, the N⁻-type semiconductor substrate 301 is prepared, and its front side surface is thermally oxidized to form an oxide film 305a. Then, a gate electrode material 306a such as polysilicon or the like is deposited on the oxide film 305a.

Then, as shown in Fig. 30, the gate oxide films 305 and the gate electrodes 306 are formed by performing photolithography and etching processes to the oxide film 305a and the gate electrode material 306a. Then, a P-type impurity such as boron or the like is ion-implanted using the gate electrode 306 as a mask to form the P-type base regions 303. A photoresist pattern is selectively formed having openings in predetermined positions on the base regions 303, and then a high concentration of N-type impurity such as phosphorus or the like is ion-implanted thereto to form the N⁺-type emitter regions 304.

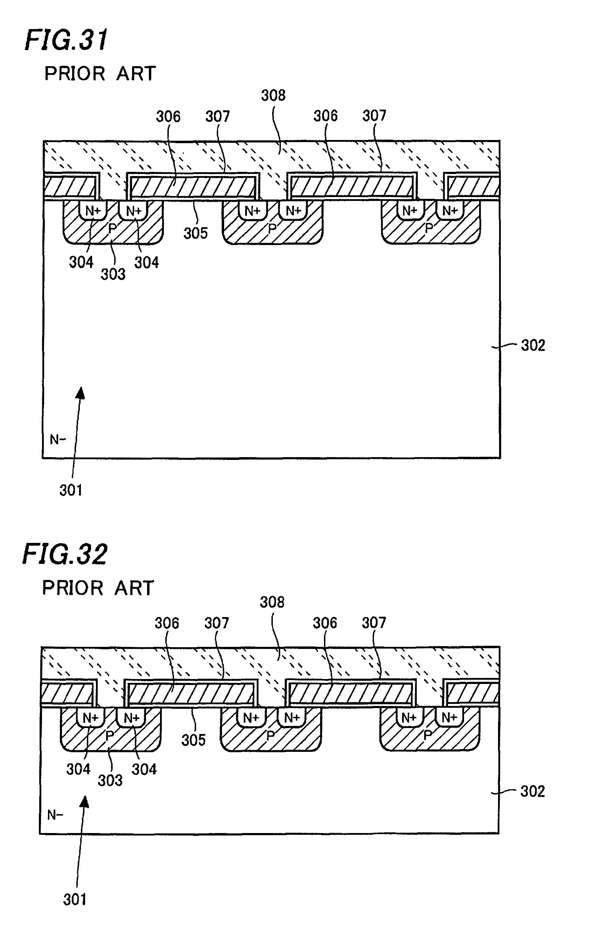

Then, as shown in Fig. 31, an insulation film is formed over the front surface side of the semiconductor substrate 301, and then photolithography and etching processes are performed to form the insulation film 307 having openings in positions above the emitter regions 304. Then, Al or the like is embedded in the openings and covers the insulation film 307 to form the emitter electrode 308 connected with the emitter regions 304.

Then, as shown in Fig. 32, the semiconductor substrate 301 is ground from its back surface side to form the drift region 302 of about 90 µm so as to obtain a breakdown voltage of, for example, 600V.

Then, as shown in Fig. 28 described above, with the thickness and the strength being reduced, a P-type impurity such as boron or the like is ion-implanted to the back surface side of the semiconductor substrate 301, and a heat treatment is performed thereto, thereby forming the P⁺-type collector region 310. Then, Al or the like is vapor-deposited on the back surface side of the semiconductor substrate 301 to form the collector electrode 311 connected to the collector region 310.

At this time, the mechanical strength of the semiconductor substrate 301 is reduced since it is thinned, so that the heat treatment in processing the back surface of the semiconductor substrate easily causes the semiconductor substrate 301 to warp.

For solving this problem, in the conventional device, the strength is kept by attaching a supporting substrate or the like to the front side of the semiconductor substrate 301 when the back surface of the semiconductor substrate 301 is ground. Then, the back surface of the semiconductor substrate 301 is further processed with the supporting substrate still being attached.

However, the above-described method requires the supporting substrate itself, processes of attaching and removing the supporting substrate, or the like, thereby increasing the cost. Furthermore, the strength of the semiconductor substrate 301 in the completed device is still low, so that a difference in coefficient of thermal expansion between the collector electrode and the semiconductor substrate easily causes the semiconductor substrate to warp.

### SUMMARY OF THE INVENTION

The solution according to the invention resides in the features of the independent claims and preferably in those of the dependent claims.

The invention provides a semiconductor device in which a current flows in a vertical direction of a semiconductor substrate, including: a semiconductor substrate including a front surface and a back surface, the semiconductor substrate having an opening on the back surface; a MOS structure formed on the front surface of the semiconductor substrate; and a back surface electrode formed in the opening.

The invention also provides a method of manufacturing a semiconductor device including: forming a MOS structure on a front surface of a first conductive type semiconductor substrate; forming a photoresist pattern on a back surface of the semiconductor substrate; forming an opening by etching using the photoresist pattern as a mask; and forming a back surface electrode in the opening.

### BRIEF DESCRIPTION OF THE DRAWINGS

Figs. 1A and 1B show a plan view and a cross-sectional view of a semiconductor device of the invention.
Figs. 2 to 14 respectively show one process in a method of manufacturing the semiconductor device of the invention.
Figs. 15 to 20B show cross-sectional views of the semiconductor device of the invention.
Figs. 21 to 25 respectively show one process in the method of manufacturing the semiconductor device of the invention.
Figs. 26A and 26B show a cross-sectional view of the semiconductor device of the invention and one process in the method of manufacturing the same.
Figs. 27 and 28 show cross-sectional views of a conventional semiconductor device.
Figs. 29 to 32 respectively show one process in a method of manufacturing the conventional semiconductor device.
Figs. 33A to 33C show plan views of the semiconductor device of the invention from the back side to show a few examples of the shape of the openings 11.
Figs. 34 shows a cross-sectional view of the semiconductor device of another embodiment of the invention.

### DETAILED DESCRIPTION OF THE INVENTION

A semiconductor device and a method of manufacturing the semiconductor device of the invention will be described in detail referring to figures.

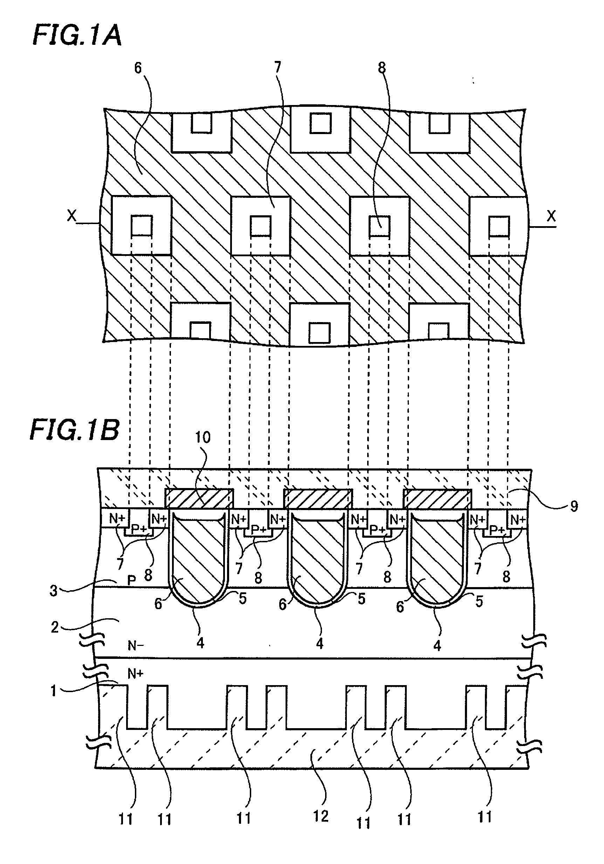

First, a case where the invention is applied to a vertical MOS transistor will be described in detail referring to Figs. 1 to 15.

Figs. 1A and 1B show the vertical MOS transistor of the invention. Fig. 1A is its plan view and Fig. 1B is a cross-sectional view along line X-X of Fig. 1A.

An N⁻-type epitaxial layer 2 is formed on an N-type semiconductor substrate 1, and a P-type channel layer 3 is formed on its front surface.

Trench grooves 4 are formed from the front surface of the channel layer 3 to the epitaxial layer 2. Conductive layers made of polysilicon films are embedded in the trench grooves 4 to form gate electrodes 6, being surrounded by insulation layers 5.

N⁺-type source layers 7 are formed on the front surface of the epitaxial layer 2, being adjacent to the trench grooves 4, and P⁺-type body layers 8 are formed between the adjacent source layers 7. Then, a source electrode 9 made of, for example, Al is formed, being electrically connected with each of the source layers 7. Here, conduction types N⁺, N, N⁻ and the like are part of one general conductivity type, and conductivity types P⁺, P, P⁻ and the like are part of another general conductivity type.

Openings 11 are formed on a back surface of the semiconductor substrate. In other words, recess portions are formed from the back surface of the substrate toward its front surface.

A drain electrode 12 made of, for example, Al is formed in the openings 11.

In this embodiment, the drain electrode 12 in the openings 11 replaces a part of the semiconductor substrate as a current path. Therefore, the invention realizes the equivalent low resistance without thinning the semiconductor substrate 1.

Next, a method of manufacturing the vertical MOS transistor of the invention will be described.

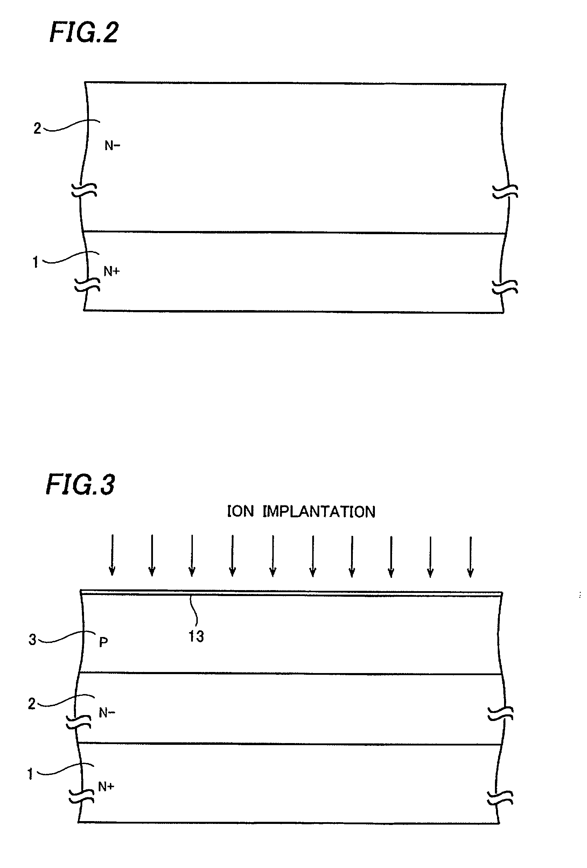

First, as shown in Fig. 2, the N⁻-type epitaxial layer 2 having a thickness of, for example, 10µm is grown on the front surface of the semiconductor substrate 1 having a thickness of, for example, 200µm.

Then, as shown in Fig. 3, B (boron), BF₂ (boron difluoride) or the like are ion-implanted to the epitaxial layer 2 and a heat treatment is performed thereto to form the P-type channel layer 3 having a thickness of, for example, 1.5 µm on the front surface of the epitaxial layer 2. An oxide film 13 is formed on the front surface of the channel layer 3 by this heat treatment.

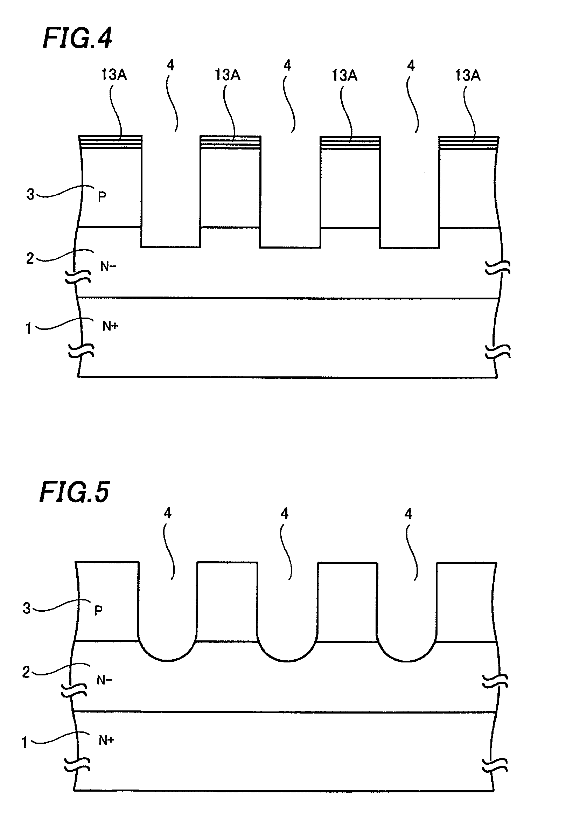

Then, as shown in Fig. 4, a composite film 13A made of a nitride film, an oxide film, or the like is formed on the oxide film 13 by CVD and patterned by a photolithography process. Then, etching is performed using the composite film 13A as a mask to form trenches 4 each having an opening diameter of, for example, 0.4 µm and reaching the epitaxial layer 2.

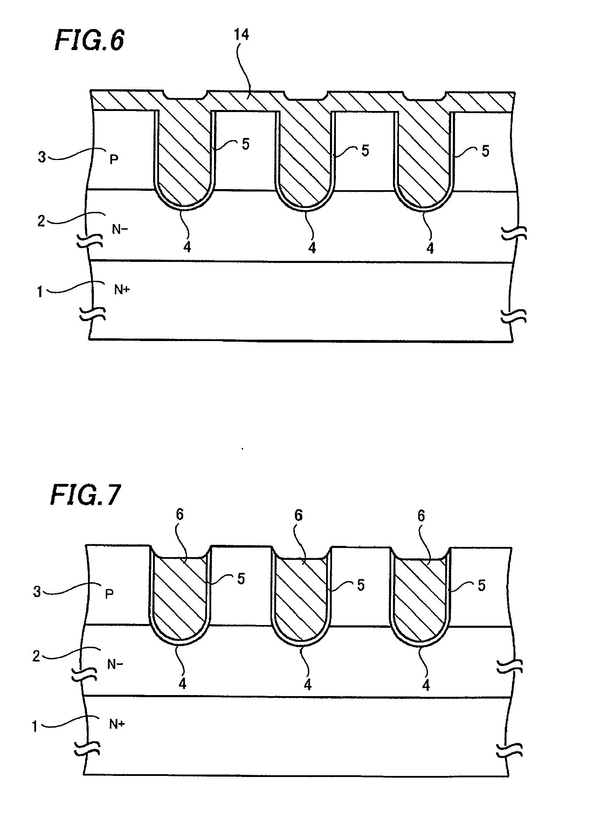

Then, as shown in Fig. 5, the composite film 13A is removed by etching, and then a heat treatment or the like is performed to round opening corners and bottom corners of the trenches 4.

Then, as shown in Fig. 6, the oxide films 5 are formed in the trenches 4 by thermal oxidation and a polysilicon layer 14 is deposited thereon by CVD.

Then, as shown in Fig. 7, the polysilicon layer 14 is etched back to form the gate electrodes 6. At this time, it is preferable to perform the etching until upper ends of the gate electrodes 6 come to positions lower than the front surface of the channel layer 3 by several µm.

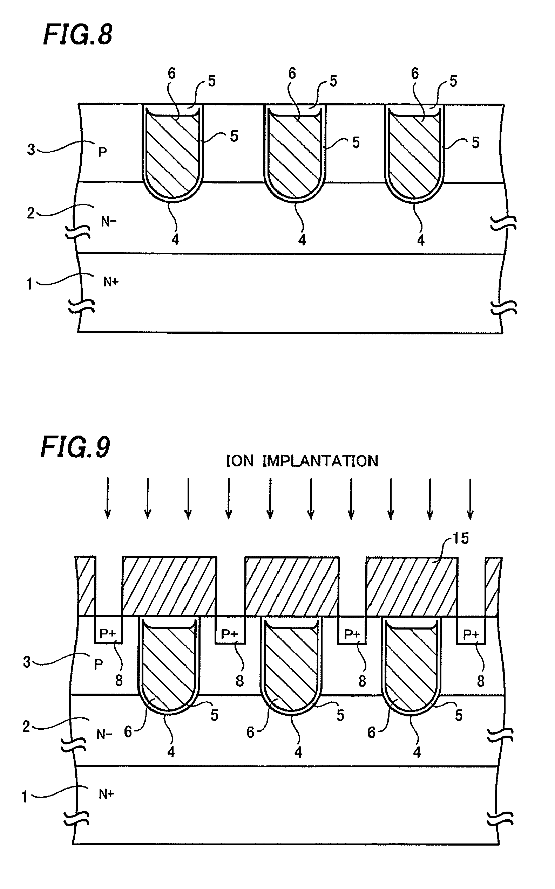

Then, as shown in Fig. 8, an oxide film is deposited on the gate electrodes 6 and the oxide films 5 by CVD, and etched back until the front surface of the channel layer 3 is exposed. By this process, the upper surface side of the gate electrodes 6 is thoroughly covered by the oxide films 5.

Then, as shown in Fig. 9, a resist film 15 is formed, and then B (boron), BF₂ (boron difluoride), or the like is ion-implanted to the channel layer 3 and a heat treatment is performed thereto in an oxygen atmosphere or a nitrogen atmosphere to form the P⁺-type body layers 8.

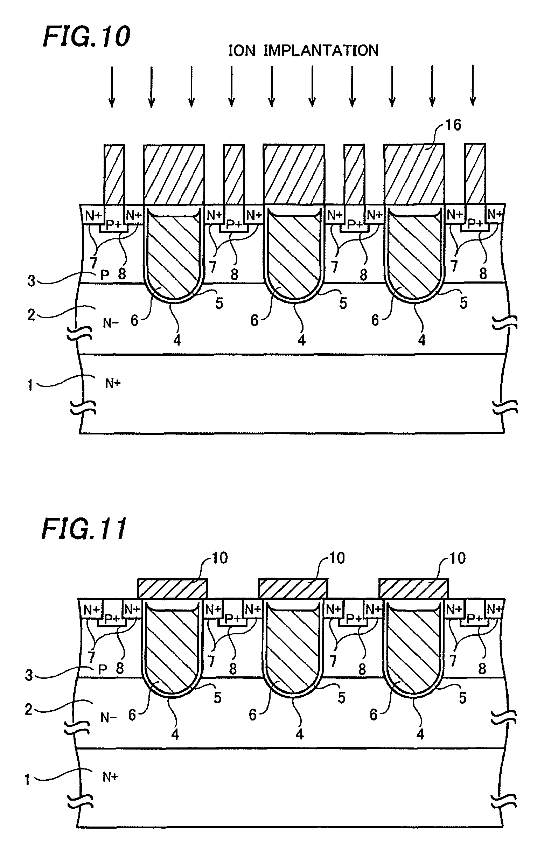

Then, as shown in Fig. 10, a resist film 16 is formed, and then As (arsenic) or the like is ion-implanted to the upper surface of the channel layer 3 and a heat treatment is performed thereto to form the N⁺-type source layers 7.

Then, as shown in Fig. 11, the whole surface of the substrate is covered with an insulation film such as a BPSG film, and the insulation film is patterned so as to expose the source layers 7 and the body layers 8, thereby forming the element isolation films 10.

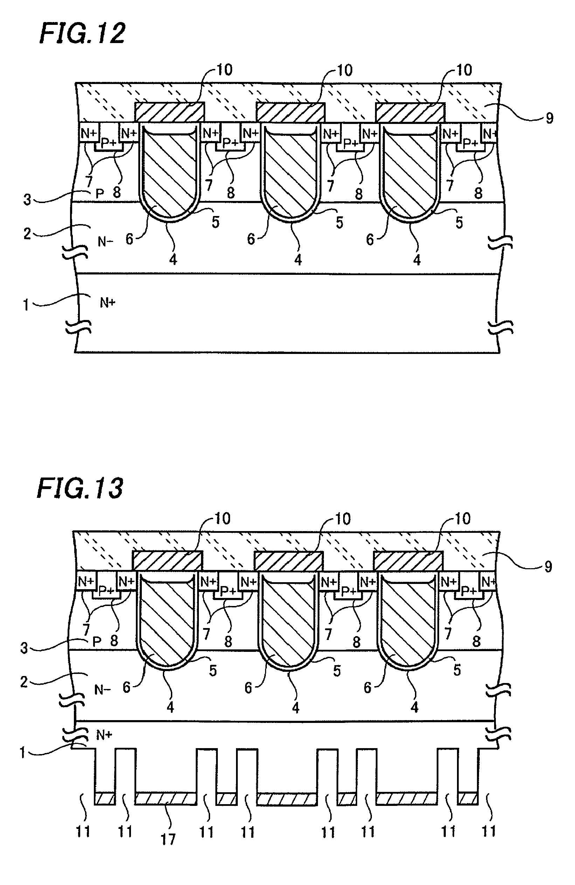

Then, as shown in Fig. 12, the front surface of the semiconductor substrate 1 is covered with a metal material such as aluminum by a sputtering or evaporation process, and photoetching and alloying are performed thereto to form the source electrode 9.

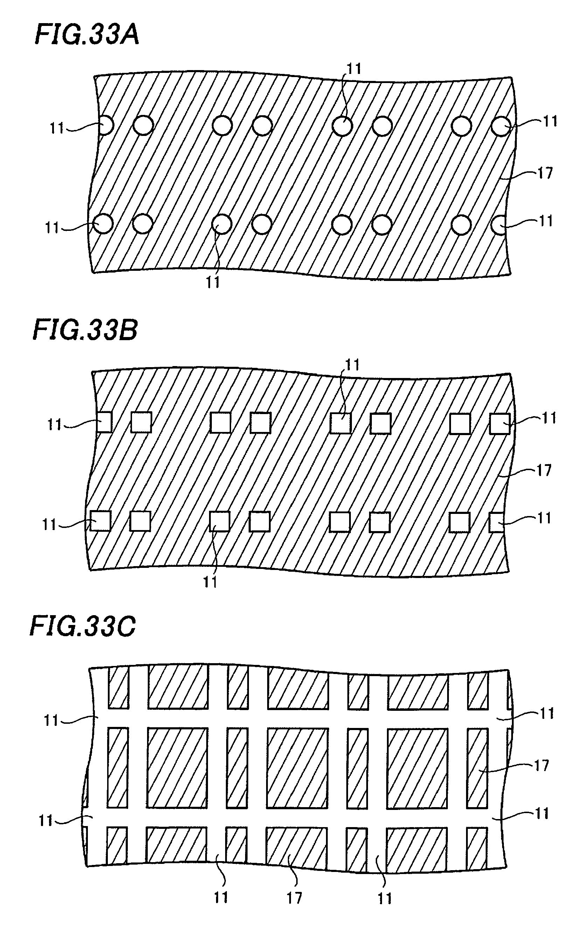

Then, as shown in Fig. 13, a resist film 17 is formed on the back surface of the semiconductor substrate 1, and then the semiconductor substrate 1 is etched using the resist film 17 as a mask to form the openings 11 such as holes or grooves each having an opening diameter of, for example, 25 to 30 µm. It is preferable to form the openings 11 under the source layers 7. The shape of the opening 11 in its back plan view may be a circle as shown in Fig. 33A, a square as shown in Fig. 33B, or a slit-like form as shown in Fig. 33C, and there is no limitation in the shape. This is also applied to the shapes of openings 109, 111, 11a, and 11b which will be described below.

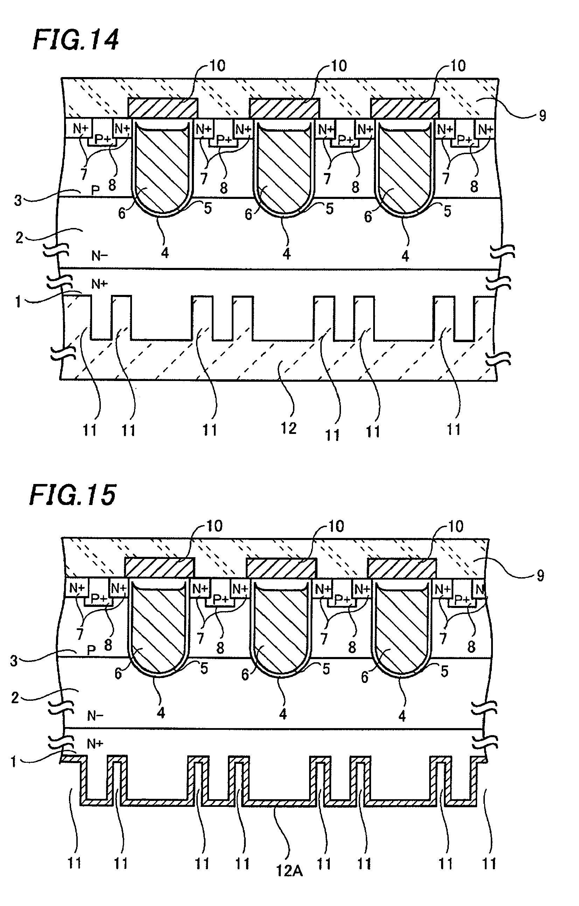

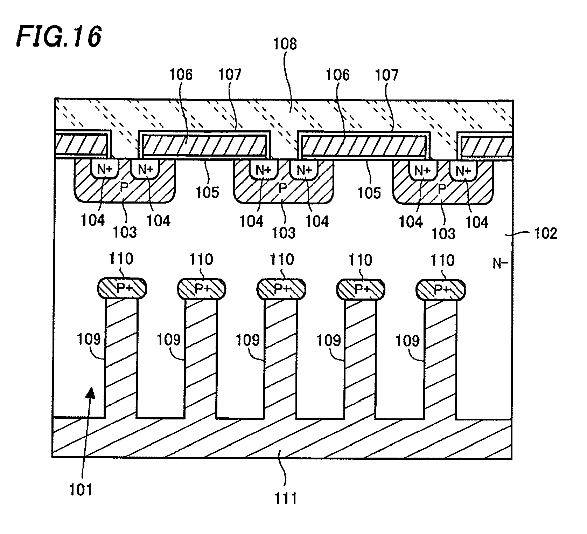

Then, as shown in Fig. 14, a barrier layer (not shown) and a seed layer (not shown) are formed on the back surface of the semiconductor substrate, and then a drain electrode 12 made of, for example, a Cu layer is formed thereon. As shown in Fig. 15, it is also possible that the drain electrode 12A is formed thin on the surfaces of openings 11 instead of filling the openings 11.

In the invention, the reduction of on-resistance is achieved by forming the openings 11 as described above, and thus the semiconductor substrate 1 is prevented from warping even when it undergoes the heat treatment.

Next, a case where the invention is applied to an NPT type IGBT will be described in detail referring to Figs. 16 to 25.

Fig. 16 shows a cross-sectional view of the NPT type IGBT of the invention.

A MOS structure is formed on a front surface side of an N⁻-type semiconductor substrate 101. In detail, P-type base regions 103 are selectively formed on a front surface of an N⁻-type drift region 102. Furthermore, N⁺-type emitter regions 104 are selectively formed on front surfaces of the base regions 103. It is noted that in the structure on the front surface side the emitter regions 104 have the equivalent functions to the source and drain of the MOS transistor. Then, gate electrodes 106 are formed so as to cover the front surfaces of the base regions 103 at least between the emitter regions 104 and the drift regions 102, with a gate oxide film 105 interposed therebetween. Polysilicon, polycide or the like is used as an electrode material to form the gate electrodes 106, for example. Furthermore, the gate electrodes 106 are surrounded by the insulation film 107. The insulation film 107 may have any other shape as long as it covers the gate electrodes 106 and has openings on the emitter regions 104. The emitter electrode 108 is formed over the insulation film 107, being connected with the emitter regions 104. The emitter electrode 108 is made of, for example, Al, Cu or the like.

Openings 109, or recess portions, are formed on a back surface side of the semiconductor substrate 101. As described below, the depths of the openings 109 determine the effective depth of the drift region 102. In detail, when a NPT type IGBT of a low breakdown voltage is to be formed, the effective depth of the drift region 102 need be shallow, so that the openings 109 need be formed deep. When the thickness of the semiconductor substrate 101 is 150 µm, for example, for forming an NPT type IGBT of a breakdown voltage 600V, the openings 109 are formed to have the depth about 60 µm.

Furthermore, P⁺-type collector regions 110 are formed on the bottoms of the openings 109. The collector regions 110 supply holes to the drift region 102 when the semiconductor device turns on, so that an impurity concentration therein is determined according to the desired on-resistance. In detail, when the impurity concentration of the collector regions 110 is high, many holes are supplied to the drift region 102 and the on-resistance is low. However, when the impurity concentration of the collector regions 110 is too high, the time taken to discharge electrons accumulated in the collector regions 110 therefrom increases when the semiconductor device turns off. That is, the turn-off time increases in this case, providing unsuitable characteristics for switching or the like.

In the semiconductor device of the invention, the collector regions 110 are formed only on the bottoms of the openings 109. Therefore, the FWD (Free Wheeling Diode) is included in the IGBT, so that the number of processes and components is reduced in an inverter such as a motor driver or the like. In detail, when the gate electrodes 106 are shifted from on to off, that is, when only a gate voltage of 0V or lower than a threshold is applied between the emitter electrode 108 and the gate electrodes 106 in the state where a collector voltage is applied between the emitter electrode 108 and the collector electrode 111, the channel regions turn back to the p-type and electrons are not injected from the emitter electrode 108 to the drift layer 102. Therefore, holes are not injected from the collector layers 110 to the drift layer 102 and the resistance of the drift region becomes high, so that a collector current does not flow. In this state, when a voltage is applied between the emitter electrode 108 and the collector electrode 111 by a load of a motor connected to an external element, for example, a forward current flows through the emitter electrode 108, the base regions 103, the drift layer 102, the peripheries of the openings 109, and the collector electrode 111. That is, a current path from the emitter electrode 108 to the collector electrode 111 includes a current path which does not pass the collector regions 110, and this current path functions as the FWD.

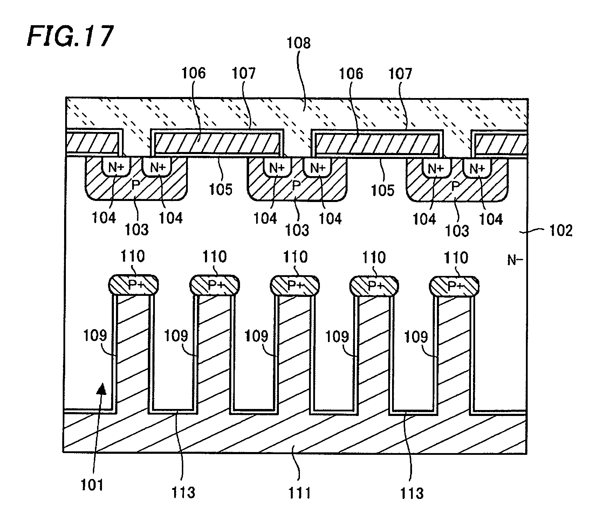

The collector electrode 111 is embedded in the openings 109, being electrically connected with the collector regions 110. Cu, Al, polysilicon or the like is used as an electrode material of the collector electrode 111, for example. As shown in Fig. 17, the collector electrode 111 may be formed in the openings 109 with an insulation film 113 interposed therebetween.

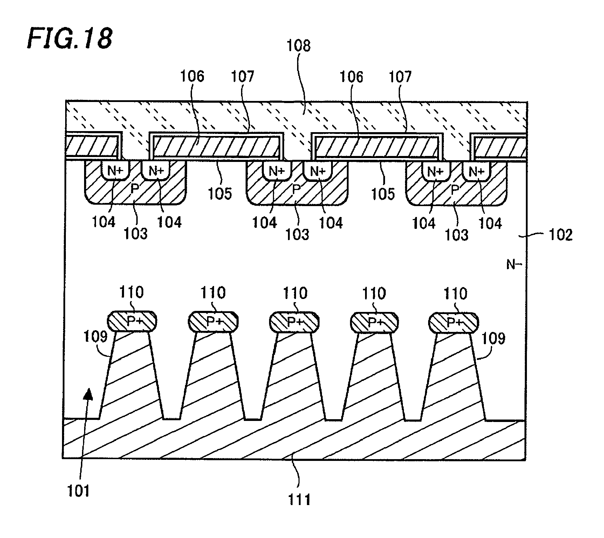

Although the openings 109 are formed vertically in the depth direction with constant crosssections, the invention is not limited to this. For example, as shown in Fig. 18, the openings 109 may be formed so that the crosssections gradually decrease from the back surface side of the semiconductor substrate 101 toward those surfaces contacting the collector regions 110. In this case, ions hardly impact against the sidewalls of the openings in the ion-implantation for forming the collector regions 110.

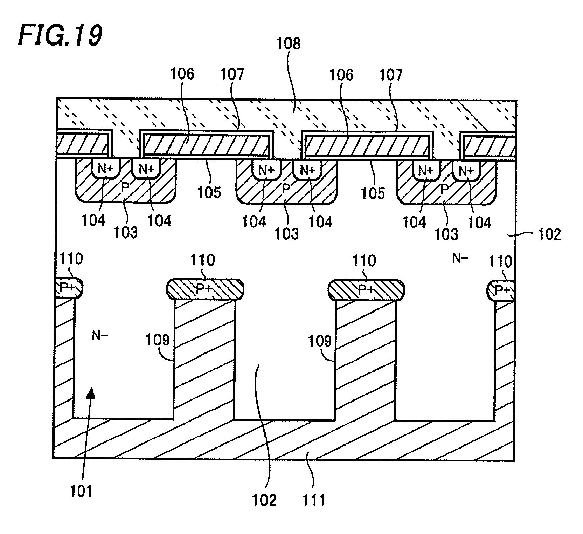

The current efficiency is enhanced by preferably forming each of the collector regions 110 between the base regions 103 as shown in Fig. 19. In detail, when the semiconductor device turns on, electrons are supplied between the base regions 103 through the channels formed in the base region 102 under the gate electrodes 106 on the front surface side of the semiconductor substrate 101. Therefore, the electrons flow in the shortest distance between the front surface and the back surface.

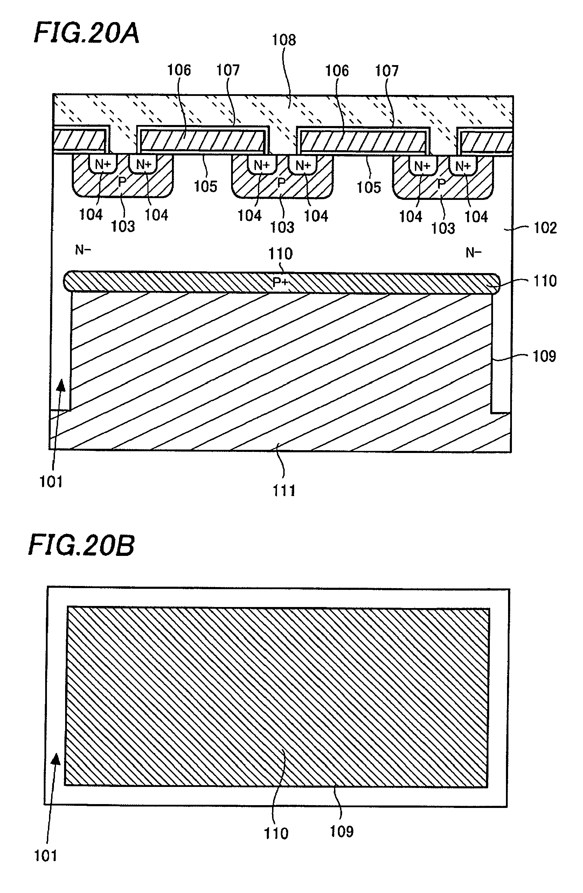

As shown in Fig. 20A and Fig. 20B showing a plan view of Fig. 20A, a pair of the opening 109 and the collector region 110 may be formed in one element. With this structure, too, the semiconductor substrate 101 surrounding the collector electrode 111 contributes to the enhancement of the mechanical strength.

Next, an operation of the NPT type IGBT of the invention will be described.

When a positive voltage is applied to the gate electrodes 106 in the state where a positive voltage is applied to the collector electrode 111, channels are formed in the base region 102 under the gate electrodes 106. In this device, the collector regions 110 are formed in more adjacent positions to these channels than the lower end of the drift region 102. Therefore, when electrons are supplied from these channels to the drift region 102, these electrons easily flow toward the collector regions 110 concentratedly regardless of the shape of the collector electrode. Then, the density of electrons supplied to the collector regions 110 increases, and accordingly the density of holes supplied from the collector regions 110 to the drift region 102 increases, thereby reducing the on-resistance. On the other hand, when the semiconductor device turns off, the electrons accumulated in the collector region 110 easily reach the collector electrode 111 and is discharged directly from the collector electrode 111.

As described above, the NPT type IGBT of the invention has low on-resistance and short turn-off time without thinning the semiconductor substrate, and is suitable for a switching element or the like.

Next, a method of manufacturing the semiconductor device of the invention will be described.

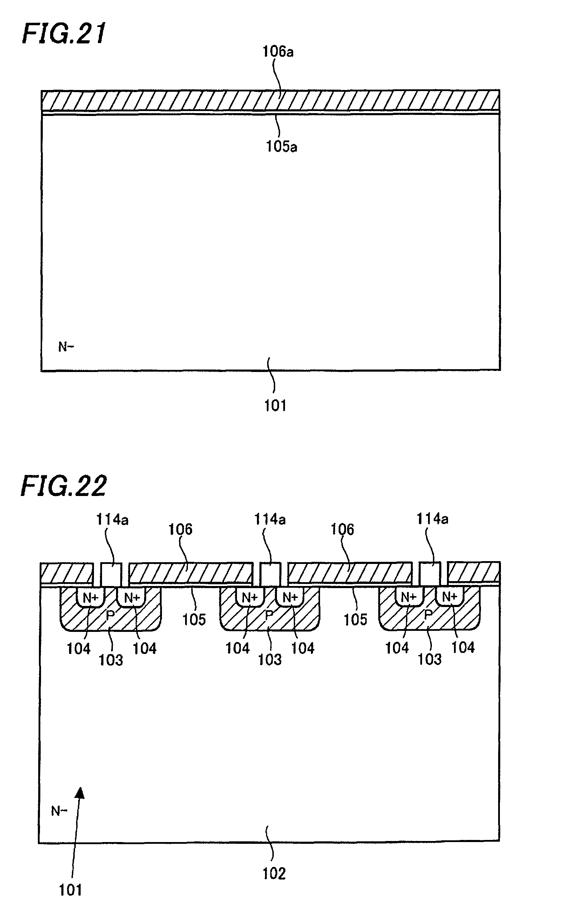

First, as shown in Fig. 21, the N⁻-type semiconductor substrate 101 is prepared. Then, the front surface of the semiconductor substrate 101 is thermally oxidized to form an oxide film 105a. Then, a gate electrode material 106a is further deposited on the oxide film 105a. Polysilicon, polycide or the like is employed as the gate electrode material 106a, for example.

Then, as shown in Fig. 22, photolithography and etching processes are performed to the oxide film 105a and the gate electrode material 106a to form the gate oxide films 105 and the gate electrodes 106. A P-type impurity such as boron or the like is ion-implanted to the substrate 101 using the gate electrodes 106 as a mask to form the P-type base regions 103. Furthermore, a photoresist film 114a is formed having openings in predetermined positions on the base regions 103, and then a high concentration of N-type impurity such as phosphorus or the like is ion-implanted to the base regions 103 and a heat treatment is performed thereto to form the N⁺-type emitter regions 104. In a case where the adjacent emitter regions 104 are connected to each other by the heat treatment, a high concentration of P-type impurity is ion-implanted in positions to separate the emitter regions 104 in order to separate each of the emitter regions 104. In the semiconductor substrate 101, a region except the base regions 103 and the emitter regions 104 is defined as the drift region 102.

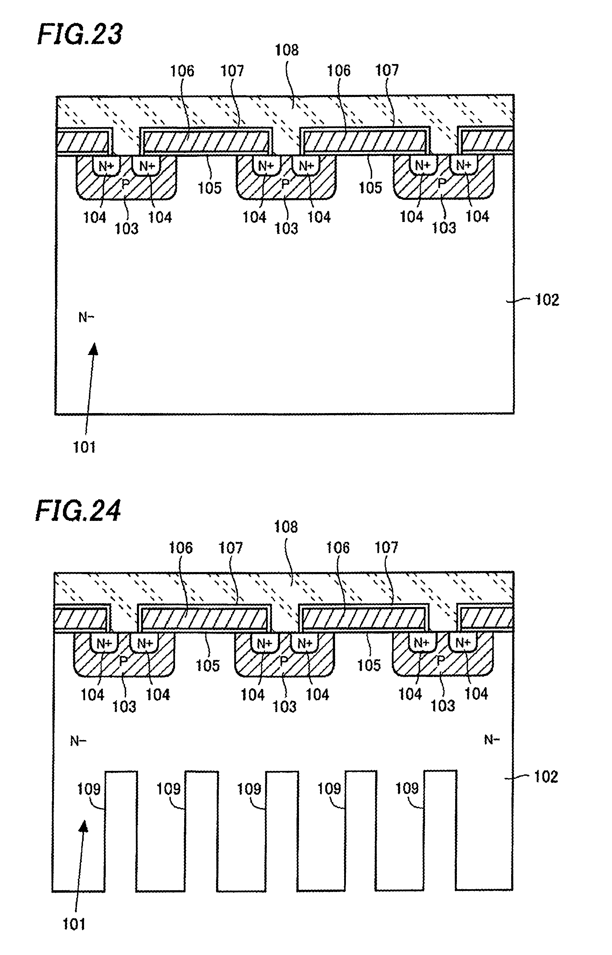

Then, as shown in Fig. 23, an insulation film is formed over the whole front surface of the semiconductor substrate 101, and then photolithography and etching processes are performed thereto to form the insulation film 107 having openings in positions corresponding to the emitter regions 104. Furthermore, an emitter electrode material such as Al or the like is embedded in the openings so as to be connected with the emitter regions 104, forming the emitter electrode 108.

Then, as shown in Fig. 24, a photoresist pattern is formed on the back surface side of the semiconductor substrate 101, and then etching is performed thereto using this photoresist pattern as a mask to form the openings 109. The depths of the openings 109 determine the effective thickness of the drift region 102. That is, since the collector regions 110 are formed on the bottoms of the openings 109 in the subsequent process, the distance between channels formed when the semiconductor device turns on and the collector regions 110 depends on the depths of the openings 109. For example, when the thickness of the semiconductor substrate 101 is about 150 µm, for forming the IGBT of a breakdown voltage 600V, the back surface of the semiconductor substrate 101 is etched by about 60 µm for forming the openings 109 so that the effective thickness of the drift region is 90 µm.

The openings 109 may form various shapes depending on a desired function, and an etching method is differently selected depending on the shape. For example, for forming the openings 109 vertically extending in the depth direction, anisotropic etching is preferably selected or the Bosch process may be selected. The Bosch process vertically etches the substrate deep by alternately repeating a plasma etching process mainly using SF₆ gas and a plasma deposition process mainly using C₄F₈ gas. However, the Bosch process may cause the inner wall surfaces of the openings 109 to have a rough wavy form, and this form may cause problems in the subsequent processes. For example, in the process of forming the collector regions 110 on the bottoms of the openings 109 by ion-implantation, the rough wavy surface may be an obstacle of the ion-implantation. The rough wavy surface may also be an obstacle when the openings 109 which are formed fine are filled with the electrode material, providing a difficulty in completely filling the openings 109 with the electrode material. For solving these problems, it is preferable to further perform dry-etching after the Bosch process to planarize the inner walls of the openings 109, for example. Isotropic etching may also be selected when the openings 109 have enough intervals therebetween.

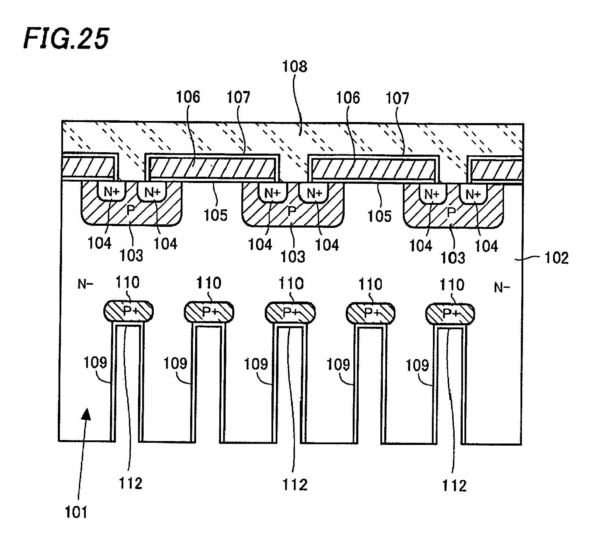

Then, as shown in Fig. 25, a heat treatment is performed to form a thin protection oxide film 112 in the openings 109. Then, a P-type impurity is ion-implanted in the vertical direction to form the P⁺-type collector regions 110 on the bottoms of the openings 109. This ion-implantation is performed using boron under the condition of the concentration of 1×10¹³/cm² and the acceleration energy of 50 keV, for example. In the ion-implantation, it is difficult to implant ions in the accurate vertical direction, and thus some of the ions are accelerated in the oblique direction. In this point of view, in this embodiment, since the protection oxide film 112 is formed in the openings 109, ions are not implanted in the sidewalls of the openings 109. Although the protection oxide film 112 is also formed on the bottoms of the openings 109, the ions are accelerated enough in the vertical direction, and the ions are sufficiently implanted in this direction.

Then, after the protection oxide film 112 is removed, a predetermined photoresist pattern is formed and then a collector electrode material is embedded in the openings 109 to form the collector electrode 111 connected to the collector regions as shown in Fig. 16. Cu or Al is used as this collector electrode material, for example. Polysilicon may be used as the collector electrode material, and this enhances the stability since it provides a small difference in coefficient of thermal expansion between the collector electrode 111 and the semiconductor substrate 101.

In the invention, as described above, the effective thickness of the semiconductor substrate is reduced corresponding to the depths of the openings and the semiconductor substrate is prevented from warping, without thinning the semiconductor substrate.

It is noted that the disclosed embodiments are only illustrative in all aspects. The scope of the invention is defined by claims but not by the above descriptions of the embodiments. The claimed invention includes the equivalents of the claimed invention and all modifications within the scope of the claims.

For example, in the embodiments, the gate electrodes 6 are formed in the trench grooves 4 in the vertical MOS transistor, and the gate electrodes 106 are formed on the semiconductor substrate 101 in the NPT type IGBT. However, the invention is not limited by the structure of the gate electrodes. For example, the gate electrodes may be formed on the semiconductor substrate in the vertical MOS transistor, and the gate electrodes may be of a trench type in the NPT type IGBT.

Furthermore, the embodiments are described on a case where the drain electrode 12 does not fill the openings 11 but is formed thin in the openings 11 in the vertical MOS transistor as shown in Fig. 15. In the NPT type IGB, too, the collector electrode 111 may be formed thin in the openings 109 instead of filling the openings 109. Forming the drain electrode 12 and the collector electrode 111 thin in this manner leads to a low cost and reduces the warping of the semiconductor substrates 1 and 101 caused by the difference in coefficient of thermal expansion.

Furthermore, the epitaxial layer 2 is formed on the semiconductor substrate 1 in the vertical MOS transistor, while the epitaxial layer is not formed on the semiconductor substrate 101 in the NPT type IGBT. However, the invention is applicable regardless of the formation of the epitaxial layer.

Furthermore, in the NPT type IGBT of the embodiment, the openings 109 are formed except in the periphery of the semiconductor substrate 101 as shown in Fig. 20. However, this may be applied to the vertical MOS transistor similarly.

Furthermore, in the description of the embodiments, the number of the openings 11 and 111 are the same as that of the gate electrodes 6 and 206. However, the invention is not limited to this, and the more number of the finer openings 11 and 111 may be randomly formed than the number of the gate electrodes 6 and 206. In this case, the concentration of the current density hardly occurs even without aligning the openings 11 and 111 and the gate electrodes 6 and 206.

Furthermore, in the description of the embodiments, all the openings 11 and 111 are formed to have the same shapes. However, the invention is not limited to this, and the openings 11 and 111 may be formed to have different diameters and depths, for example.

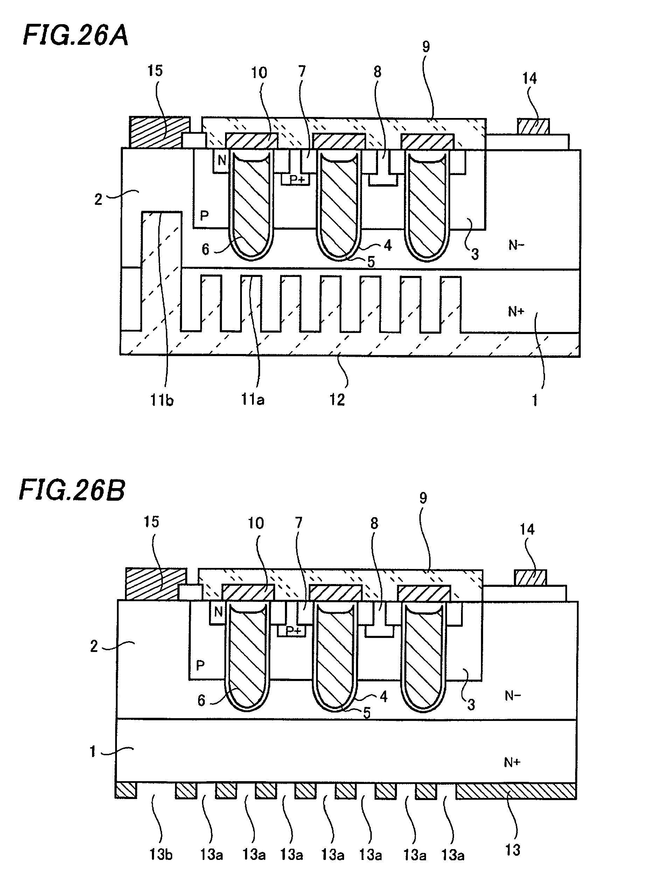

For example, in the vertical MOS transistor shown in Fig. 26A, the source electrode 9, the gate terminal 14, and the drain terminal 15 are formed on the front surface side. The gate terminal 14 is a terminal electrically connected with the gate electrodes 6 through a connection wiring (not shown). The drain terminal 15 is a terminal for leading a drain current from the drain electrode. Since the source electrode 9, the gate terminal 14, and the drain terminal 15 are formed on the same surface, the vertical MOS transistor may be packaged facedown.

With this structure, an opening 11b formed under the drain terminal 15 is formed deeper than openings 11a formed under the source electrode 9. That is, while a channel layer 3 is not formed under the drain terminal 15, the drain electrode 12 extends to the periphery of the drain terminal 15, thereby reducing the resistance. This enables a drain current to easily flow from the drain electrode 12 to the drain terminal 15.

Furthermore, since a current path of a drain current is not formed under the gate terminal 14, the opening 11 is not necessarily formed there.

By preferably designing the opening 11b having a larger diameter than diameters of the openings 11a, these are simultaneously formed by performing the etching once.

In detail, as shown in Fig. 26B, by patterning a resist film 13 for etching the back surface of the semiconductor substrate 1 such that a position 13b corresponding to the opening 11b has a larger diameter than each of positions 13a corresponding to the openings 11a, the openings 11a and 11b are simultaneously formed by performing the etching once using this resist film 13 as a mask. For example, the openings 11a and 11b are designed to have the ratio of the opening diameters 1:4, more specifically, each of the openings 11a are designed to have a diameter of about 10 µm and the opening 11b is designed to have a diameter of about 40 µm. This is based on a difference in the micro loading effect between the positions 13a and 13b where the semiconductor substrate 1 is etched. That is, as the diameter of the opening 11 is larger, etching gas enters the opening 11 more easily, the residues occurring in the etching is discharged more easily, and an etching speed is more increased.

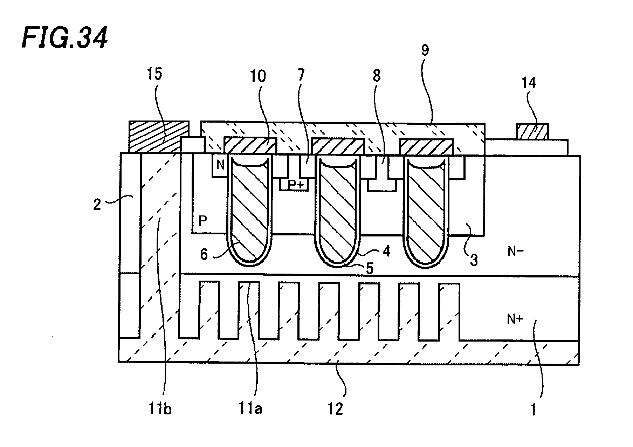

Although the opening 11b is formed extending to the middle of the epitaxial layer 2 in Fig. 26A, the invention is not limited to this, and, for example, the opening 11b may be formed penetrating the epitaxial layer 2 to the drain terminal 15 as shown in Fig. 34. With this structure, a drain current is easily and effectively led from the drain electrode 12 to the drain terminal 15.

This embodiment where the openings 11 are formed into different shapes may be applied to the IGBT similarly.

In the invention, the effective thickness of a semiconductor substrate is reduced corresponding to the depths of the openings and the semiconductor substrate is prevented from warping.

In the IGBT, the collector regions are formed only on the bottoms of the openings but not entirely in the openings. Therefore, the amount of holes supplied from the collector regions to the drift region is limited as designed, and the turn-off time is easily adjusted. Furthermore, the FWD is included in the IGBT.

## Claims

1. A semiconductor device comprising:
- a semiconductor substrate (1, 101) comprising a front surface and a back surface, a recess portion (11, 109) being formed from the back surface toward the front surface;
- a MOS structure formed on the front surface of the semiconductor substrate (1, 101); and
- a back surface electrode (12, 111) formed in the recess portion (11, 109),
wherein the semiconductor device is configured to form a current flow between the front and back surfaces of the semiconductor substrate (1, 101).

2. The semiconductor device of claim 1, wherein the semiconductor substrate (1) is of a first general conductive type, the MOS structure comprises a channel layer (3) of a second general conductivity type formed on the front surface of the semiconductor substrate (1), a plurality of gate insulation films (5) and gate electrodes (6), a source layer (7) of the first general conductivity type formed adjacent the gate insulation films (5), a source electrode (9) electrically connected with the source layer (7) and a drain layer electrically connected with the back surface electrode (12) at a bottom of the recess portion (11), and the back surface electrode (12) comprises a drain electrode.

3. The semiconductor device of claim 1, wherein the semiconductor substrate (101) is of a first general conductive type, the MOS structure comprises a base region (103) of a second general conductive type formed on the front surface of the semiconductor substrate (101), a plurality of gate insulation films (107) and gate electrodes (106), a emitter region (104) of the first general conductivity type formed adjacent the gate insulation films (107), an emitter electrode (108) electrically connected with the emitter region (104) and a collector region (110) of the second general conductivity type electrically connected with the back surface electrode (111) at a bottom of the recess portion (109), and the back surface electrode (111) comprises a collector electrode.

4. The semiconductor device of claim 1, wherein the semiconductor substrate (1, 101) has a thickness sufficient for mechanically supporting the semiconductor device.

5. The semiconductor device of claim 2, wherein the gate electrode (6) is of a trench type.

6. The semiconductor device of claim 2, wherein the recess portion (11) is formed under the source layer (7).

7. The semiconductor device of claim 3, wherein the gate electrode (106) is of a trench type.

8. The semiconductor device of claim 3, wherein the recess portion (109) is formed under the emitter region (104).

9. The semiconductor device of claim 4, wherein the recess portion (109) is not formed in a circumference portion of the semiconductor substrate (101).

10. The semiconductor device of claim 1, wherein an insulation film (12A, 113) is formed on a sidewall of the recess portion (11, 109).

11. The semiconductor device of claim 3, wherein the current flow is configured to be formed from the emitter electrode (108) to the collector electrode (111) through the base region (103) and a side surface of the recess portion (109) is formed.

12. The semiconductor device of claim 1, further comprising a terminal (15) formed on the front surface of the semiconductor substrate (1) and configured to lead a current from the back surface electrode (12), and an additional recess portion (11b) formed from the back surface toward the front surface, wherein the recess portion (11a) is disposed under the MOS structure and the additional recess portion (11b) is disposed under the terminal (15), and the additional recess portion (11b) is deeper than the recess portion (11a).

13. The semiconductor device of claim 12, wherein the recess portion (11b) has a larger diameter than the recess portion (11a).

14. The semiconductor device of claim 12, wherein the additional recess portion (11b) extends so as to contact the terminal (15).

15. A method of manufacturing a semiconductor device, comprising:
- forming a MOS structure on a front surface of a semiconductor substrate (1, 101) of a first general conductivity type;
- forming a photoresist pattern (17) on a back surface of the semiconductor substrate (1, 101);
- forming a recess portion (11, 109) by etching the semiconductor substrate (1, 101) using the photoresist pattern (17) as a mask; and
- forming a back surface electrode (11, 111) in the recess portion (11, 109).

16. The method of claim 15, further comprising forming a collector region (110) at a bottom of the recess portion (109) by implanting an impurity of a second general conductivity type.

17. The method of claim 15, wherein the back surface electrode (111) comprises polysilicon.

18. The method of claim 15, wherein the recess portion (11, 109) is not formed in a circumference portion of the semiconductor substrate (1, 101).

19. The method of claim 15, further comprising forming a terminal (15) on the front surface of the semiconductor substrate (1) and forming an additional recess portion (11b) under the terminal (15), the additional recess portion (11b) being formed from the back surface to the front surface and larger than the recess portion (11a) that is under the MOS structure.

20. The method of claim 19, wherein the recess portion (11b) is formed so as to extend to the terminal (15) so as to contact the terminal (15).
